# EUROPÄISCHE PATENTANMELDUNG

(11) **EP 3 179 508 A1**
(43) Veröffentlichungstag der Anmeldung: **14.06.2017**
(21) Anmeldenummer: 16002743.9
(22) Anmeldetag: 19.12.2001
(51) Int. Cl.: H01L 23/48, D21H 21/48, B42D 25/355, B42D 25/305, C09J 9/02, C09J 11/04, G06K 19/077, G07D 7/00

(54) **ELEKTRISCH LEITFÄHIGE VERBINDUNG ZWISCHEN EINEM CHIP UND EINEMKOPPELELEMENT SOWIE SICHERHEITSELEMENT, SICHERHEITSPAPIER UND WERT-DOKUMENT MIT EINER SOLCHEN VERBINDUNG**

(30) Priorität: 21.12.2000 DE 10064411
(62) Teilanmeldung aus: 01986899.1
(71) Anmelder: Giesecke & Devrient GmbH, 81677 München (DE)
(72) Erfinder: Hoffmann, Lars, 93057 Regensburg (DE)

(57) **Zusammenfassung**

Ein Wertpapier besitzt einen Chip (3) und ist mit einem Koppelelement (2) zur Übertragung von Daten und/ oder Energie von und/ oder zum Chip (3) über einen Klebstoff (4) verbunden. Gemäß einer dritten Ausführungsform kann auf elektrisch leitfähige Partikel im Kleber verzichtet werden. Statt dessen erfolgt die Übertragung von Daten/ Energie über ein kapazitiv eingekoppeltes Wechselfeld mit hohen Frequenzen von etwa 2 GHz.

## Beschreibung

Die Erfindung betrifft eine elektrisch leitfähige Verbindung zwischen einem als Chip ausgebildeten integrierten Schaltkreis und einem Koppelelement zum Übertragen von Daten und/ oder Energie von und/ oder zum Chip. Die Erfindung betrifft gleichermaßen Wertdokumente, insbesondere Banknoten, sowie Sicherheitspapier zur Herstellung dieser Wertdokumente und Sicherheitselemente zur Auf- oder Einbringung auf bzw. in das Sicherheitspapier, welche jeweils eine derartige elektrisch leitfähige Verbindung zwischen Chip und zugehörigem Koppelelement besitzen. Schließlich betrifft die Erfindung noch ein Verfahren zur kapazitiven Übertragung von Daten und/ oder Energie zwischen verbundenem Chip und Koppelelement.

Wertdokumente im Sinne der vorliegenden Erfindung können Banknoten, Urkunden aber auch Kreditkarten und dergleichen sein. Die Erfindung ist besonders für den Einsatz in dünnen, papierenen Wertdokumenten wie Banknoten geeignet, ist aber auch im Zusammenhang mit anderen Wertdokumenten einsetzbar.

Das Applizieren von integrierten Schaltkreisen in Form von Chips in oder auf Banknoten wird beispielsweise in der EP 0 905 657 A1 vorgeschlagen, um mittels im Chip gespeicherter Informationen die Sicherheit von Banknoten gegenüber Fälschungen zu erhöhen. Bei dem Chip handelt es sich um einen Transponderchip, der also nicht unmittelbar von externen Datenverarbeitungsgeräten kontaktiert wird, sondern bei dem der Datenaustausch über ein als offene oder geschlossene Dipolantenne ausgebildetes Koppelelement erfolgt, wozu beispielsweise der in der Banknote enthaltene Sicherheitsfaden oder eine separat in der Banknote vorgesehene, geschlossene Spule dienen können.

Die Herstellung einer elektrisch leitenden Verbindung zwischen dem Chip und dem Koppelelement ist wegen der geringen Papierschichtdicke und wegen der geringen Dicke des Chips gewissen Beschränkungen unterworfen. Eine Verbindung mittels feinen (Gold-) Drähtchen in der Wire-Bond-Technik ist aufgrund dieser Randbedingungen ausgeschlossen. Statt dessen bietet sich die aus der Chipkartentechnologie bekannte Flip-Chip-Technik an, bei der der Chip mit seinen Kontaktelementen in eine auf dem Koppelelement aufgebrachte elektrisch leitfähige Masse eingetaucht wird. Die Verwendung eines elektrisch leitfähigen Klebers wird beispielsweise in der DE 44 16 997 A1 erwähnt.

Um sicherzustellen, daß der verwendete Kleber nicht zu einer Kurzschlußbrücke führt, insbesondere bei eng benachbarten Chipkontaktelementen, wird im Zusammenhang mit Chipkarten in EP-A-512 546 und DE 199 57 609 A1 vorgeschlagen, anisotrope Leitkleber zu verwenden, die also nur in einer Richtung, nämlich zwischen Chip und Kontaktelement, leitfähig sind. Eine solche anisotrope Kleberschicht kann alle Kontaktelemente gemeinsam überdecken, ohne daß dies zur Kurzschlußbildung führt. In der DE 199 57 609 A1 wird dazu vorgeschlagen, kugelförmige, gegebenenfalls elastische Leitkörper nebeneinander und zueinander beabstandet in einer handhabbaren, kompressiblen Heißsiegelkleberschicht vorzusehen. Beim Applizieren des Chips auf das Koppelelement in der Heißstempeltechnik wird durch Anwendung von Druck und Temperatur erreicht, daß die kugelförmigen Leitkörper eine elektrisch leitfähige Verbindung zwischen den Kontaktelementen des Chips und dem Koppelelement bilden, wobei die Leitkörper aber untereinander nicht in Verbindung kommen, so daß eine Kurzschlußbildung vermieden wird. Konkrete Angaben über die elastischen Leitkörper enthält die DE 199 57 609 A1 nicht.

Die vorgenannten Vorschläge sind nicht ohne weiteres von der Chipkartentechnologie auf die Wertpapiertechnologie übertragbar, was insbesondere auf die extrem geringe Materialstärke der Wertpapiere und Chips zurückgeführt wird. Als besonders problematisch hat sich die Gefahr des Chipbruchs bei der Applikation des extrem dünnen Chips auf das Koppelelement herausgestellt.

Aufgabe der vorliegenden Erfindung ist es daher, eine elektrisch leitfähige Verbindung vorzuschlagen, mit der insbesondere im Zusammenhang mit Wertpapieren Chips und zugehörige Koppelelemente zuverlässig miteinander verbunden werden können.

Weitere Aufgaben der Erfindung bestehen darin, entsprechende Sicherheitselemente für Wertpapiere, Wertpapiere als solche und Sicherheitspapiere zur Herstellung solcher Wertpapiere sowie ein Verfahren zur Daten- und/ oder Energieübertragung vorzuschlagen.

Diese Aufgaben werden erfindungsgemäß jeweils durch die Merkmale der anhängenden nebengeordneten Ansprüche gelöst. In davon abhängigen Ansprüchen sind vorteilhafte Ausgestaltungen und Weiterbildungen der Erfindung angegeben.

Den erfindungsgemäßen Lösungen liegt die Erkenntnis zugrunde, daß die elektrisch leitende Verbindung zwischen dem Chip und dem Koppelelement möglichst wenig mechanische Spannungen in dem bruchanfälligen Chip erzeugen soll, insbesondere nicht zum Zeitpunkt der Chipapplikation.

Gemäß einer ersten Ausführungsform der Erfindung wird diese Erkenntnis zur Lösung der vorgenannten Aufgabe so umgesetzt, daß der den Chip und das Koppelelement verbindende Kleber ein anisotroper Leitkleber ist, der elektrisch leitfähige Partikel enthält, deren maximale Größe geringer ist als der Abstand zwischen dem Chip und dem Koppelelement, vorzugsweise kleiner als 1 µm. Diese Partikel werden in dem Kleber vorzugsweise so ausgerichtet, beispielsweise in einem Magnetfeld, daß sie nur in Richtung zwischen Chip und Koppelelement leiten und im übrigen durch das Klebermaterial voneinander isoliert sind. Bei einer Kleberschichtdicke von etwa 2 µm ist somit gewährleistet, daß die Partikel aufgrund ihrer geringen Größe keine mechanischen Spannungen auf den Chip ausüben können.

Gemäß einer zweiten Ausführungsform der Erfindung wird ebenfalls ein anisotroper Kleber mit elektrisch leitfähigen Partikeln verwendet, die jedoch aus einem Lotmaterial bestehen, welches bei einer erhöhten Temperatur, bei der der Chip mit dem Koppelelement verbunden wird, weich ist. Nach Abkühlung erstarrt das Lotmaterial in seiner beim Applizieren des Chips angenommenen Form. Somit ist gewährleistet, daß insbesondere beim Applizieren des Chips keine mechanischen Spannungen von den elektrisch leitfähigen Partikeln auf den Chip ausgeübt werden. Die Lotmaterialpartikel sind in einer geeigneten Klebematrix nebeneinander und voneinander beabstandet so angeordnet, daß sie auch nach Applikation des Chips noch zueinander beabstandet sind. Hinsichtlich der Art und Weise des Applizierens des Chips und des anisotropen Klebers auf das Koppelelement sowie der möglichen Alternativen für die Gestaltung der speziellen anisotropen Kleberschicht mit voneinander beabstandeten Partikeln bzw. Leitkörpern wird hiermit auf den Inhalt der DE 199 57 609 A1 explizit Bezug genommen.

Anstelle der Verwendung eines elektrisch leitfähigen Klebers zur ohmschen Kontaktierung von Chip und Kontaktelement sieht eine dritte Ausführungsform der Erfindung eine kapazitive Kopplung vor. Diese Ausführungsform ist zur Verwendung mit hochfrequenten Wechselströmen von beispielsweise etwa 2 GHz geeignet. Jegliche mechanische Spannungen fördernden Leitpartikel in der Kleberschicht können entfallen. Statt dessen bildet die Kleberschicht eine dünne, dielektrische Schicht zwischen den Chipkontaktflächen und dem Koppelelement. Die Energiezufuhr für den Chip erfolgt über ein kapazitiv in den Chip eingekoppeltes Wechselfeld, und der Chip besitzt einen Gleichrichter und einen Kondensator zur Energiespeicherung.

Nachfolgend wird die Erfindung beispielhaft anhand der anhängenden Figuren erläutert. Darin zeigen:
Figur 1 eine elektrisch leitfähige Verbindung mit anisotropem Kleber gemäß der ersten Ausführungsform der Erfindung,
Figur 2 eine elektrisch leitfähige Verbindung mit anisotropem Kleber gemäß der zweiten Ausführungsform der Erfindung, und
Figur 3 eine elektrisch leitfähige Verbindung mit kapazitiver Kopplung gemäß der dritten Ausführungsform der Erfindung.

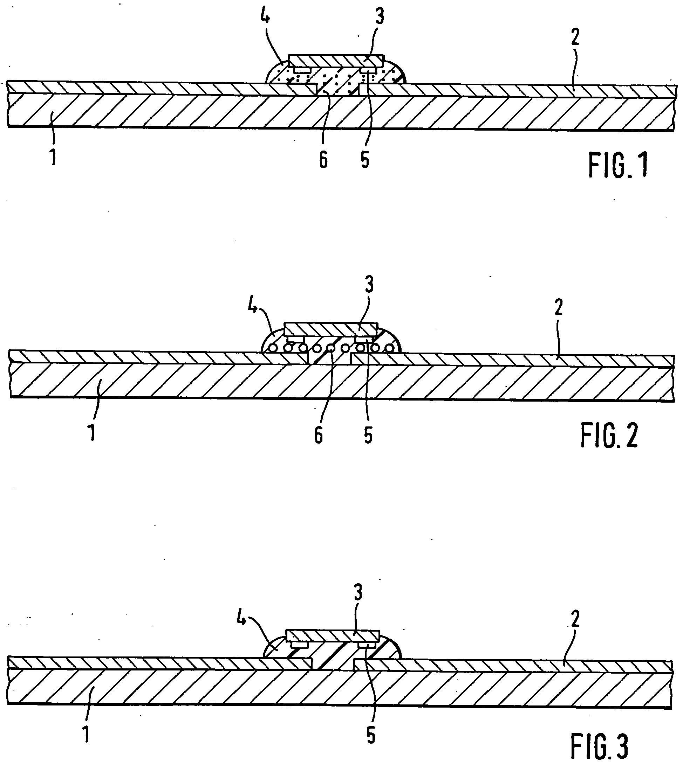

Figur 1 zeigt ein Substrat 1 mit einem Koppelelement 2 und einem mit dem Koppelelement 2 über einen Kleber 4 elektrisch leitend verbundenen integrierten Schaltkreis 3.

Bei dem Substrat 1 kann es sich um ein Wertpapier handeln, insbesondere um eine Banknote, oder auch um ein Vorprodukt eines solchen Wertpapiers, nämlich ein Sicherheitspapier, welches erst später zu einem Wertpapier weiterverarbeitet wird. Bei dem Substrat 1 kann es sich aber auch um andere Wertdokumente handeln, beispielsweise eine Chipkarte. Insbesondere kann es sich bei dem Substrat 1 auch um ein Sicherheitselement handeln, beispielsweise ein optisch variables Element (OVD) oder einen Sicherheitsfaden, welche erst später mit einem Wertdokument oder Sicherheitspapier verbunden werden. Im Falle eines OVDs würde das Sicherheitselement vorzugsweise so an dem Wertdokument angebracht, daß die optisch variable Seite des OVDs nach außen weist und das OVD den Blick auf den integrierten Schaltkreis 3 verdeckt. Wenn das optisch variable Element als Hologramm ausgeführt ist, kann das Koppelelement 2 gleichzeitig als Reflexionsschicht dienen, um das durch das optisch variable Element hindurchfallende Licht zu reflektieren.

Bevorzugt wird die Erfindung in Wertpapieren wie Banknoten verwendet. Das Substrat 1 und das Koppelelement 2 bilden darin vorzugsweise einen Sicherheitsfaden, wobei das Substrat 1 beispielsweise ein transparenter Kunststoffaden ist, auf dem das Koppelelement 2 als Aluminiumbeschichtung vorliegt. Das Koppelelement 2 stellt dann einen offenen Dipol dar, über den Daten und/ oder Energie von einem externen Gerät kontaktlos zum integrierten Schaltkreis 3 übertragen werden können. Anstelle eines Sicherheitsfadens kann der Chip 3 auch auf einem anderen Substrat oder Sicherheitselement appliziert und mit der Banknote verbunden werden, wobei es dann je nach verfügbarer Fläche möglich ist, das Koppelelement 2 als geschlossenen Dipol oder als Spule auszubilden. Im weiteren kann zumindest im Bereich des integrierten Schaltkreises 3 noch eine Kaschierfolie, die in der Figur nicht dargestellt ist, angeordnet werden.

Der integrierte Schaltkreis liegt vor seiner Applizierung als handhabbarer Chip vor. Dabei kann es sich beispielsweise um einen reinen Speicherchip (ROM), einen wiederbeschreibbaren Chip (EPROM, EEPROM) oder auch um einen Mikroprozessorchip handeln. Die verwendeten Chips besitzen eine Dicke von 5 µm bis 50 µm, vorzugsweise 10 µm, und eine Kantenlänge von circa 0,1 mm bis 3 mm, vorzugsweise 0,6 mm. Auf dem Chip 3 befinden sich vorzugsweise zwei bis vier Kontaktflächen 5.

Der Kleber 4, durch den der Chip 3 und das Koppelelement 2 fest miteinander verbunden sind, enthält elektrisch leitfähige Partikel 6.

Gemäß der Ausführungsform nach Figur 1 ist die maximale Größe dieser Partikel 6 wesentlich geringer als der Abstand zwischen den Kontaktflächen 5 und dem Koppelelement 2. Dadurch wird sichergestellt, daß beim Applizieren des Chips 3 auf das Koppelelement 2 keine mechanischen Spannungen im Chip 3 aufgrund dazwischenliegender Partikel 6 auftreten. Der Abstand zwischen den Kontaktflächen 5 und dem Koppelelement 2 beträgt vorzugsweise etwa 2 µm und die maximale Partikelgröße beträgt daher weniger als etwa 1 µm, vorzugsweise etwa 0,5 µm.

Um zu erreichen, daß die Partikel 6 innerhalb des Klebers 4 nur in Richtung von und zu den dem Koppelelement 2 nächstliegenden Kontaktflächen 5 elektrisch leitfähig sind, werden die Partikel 5 ausgerichtet, bevor der Kleber 4 soweit vernetzt ist, daß die Partikel 6 in ihrer ausgerichteten Lage weitgehend fixiert sind. Die Ausrichtung der Partikel 6 kann beispielsweise in einem Magnetfeld erfolgen, so daß benachbarte Partikel 6 aneinanderstoßen und Linien in der elektrischen Vorzugsrichtung bilden.

Als für die leitfähigen Partikel 6 geeignetes Material hat sich das von DuPont unter dem Handelsnamen "ZELEC ECP-3010XC" vertriebene leitfähige Pulver erwiesen. Ebenfalls geeignet ist Silber-Nanopulver mit einer Partikelgröße von vorzugsweise etwa 0,5 µm.

Auch die Wahl des Klebers ist nicht unbedeutend. Er muß vor mechanischer Überbeanspruchung geschützt sein und daher in Grenzen flexibel sein. Bei einer Schichtstärke von 2 µm sollte der ohmsche Durchgangswiderstand etwa 5 Ohm betragen. Desweiteren muß sichergestellt sein, daß die kleinen Kontaktflächen 5 des Chips 3 mit der Größe von jeweils etwa 70 µm x 70 µm ausreichend kontaktiert werden. Insbesondere muß eine Kontaktierung von Aluminiumschichten mit Oxidbelag gewährleistet sein, da der Kontakt des Koppelelements 2 mit der Luft eine natürliche Oxidation des Aluminiums verursacht. Schließlich muß sichergestellt sein, daß die elektrische Leitfähigkeit des Klebers im HF-Feld entgegen der Vorzugsrichtung nicht weiter als 100 µm reicht. 100 µm beträgt in etwa der Abstand zwischen benachbarten Kontaktbereichen des Koppelelements 2.

Gemäß einer zweiten Ausführungsform, die in Figur 2 dargestellt ist, bestehen die elektrisch leitfähigen Partikel 6 des anisotropen Klebers 4 aus einem Lotmaterial, beispielsweise Zinn-Wismut. Der Chip 3 wird üblicherweise in der Heißstempeltechnik auf das Koppelelement 2 aufgesetzt, wobei die eingebrachte Temperatur zu einer Aufweichung und Vernetzung des Klebers 4 und der geringfügige Druck zur Kontaktierung des Chips 3 mit den Anschlußbereichen des Koppelelements 2 führt. Die Temperatur des Heißstempels sowie die Erweichungstemperatur des Lotmaterials sind so aufeinander abgestimmt, daß auch das Lotmaterial beim Applizieren des Chips 3 erweicht und sich entsprechend dem Druck des Heißstempels formgerecht an die Kontaktflächen 5 anpaßt. Beim Applizieren des Chips 3 auf das Koppelelement 2 üben die elektrisch leitfähigen Lotmaterialpartikel somit keine wesentlichen Spannungen auf den Chip 3 aus, sondern verformen sich plastisch, stellen aber eine elektrisch leitfähige Verbindung zwischen den Kontaktflächen 5 des Chips 3 und dem Koppelelement 2 sicher. Die Lotpartikel 6 sind in dem Kleber 4 matrixartig verteilt, so daß sie nicht miteinander in Querverbindung stehen, auch nicht nach der Applizierung des Chips, so wie dies in DE 199 57 509 A1 beschrieben ist.

Als geeigneter Kleber in Verbindung mit den Lotmaterialpartikeln hat sich der unter der Bezeichnung "Loctite 3440" vertriebene Kleber erwiesen.

Gemäß einer dritten Ausführungsform, die in Figur 3 dargestellt ist, wird ein Kleber 4 verwendet, der nicht notwendigerweise elektrisch leitfähige Partikel enthält. Die Übertragung von Daten und/ oder Energie erfolgt kapazitiv zwischen dem Koppelelement 2 und den Kontaktflächen 5 des Chips 3. Diese Art der Übertragung ist besonders geeignet bei hohen Frequenzen von beispielsweise 2 GHz für die Energieübertragung, wobei der Datenstrom beispielsweise mit einer Frequenz von ca. 400 MHz aufmoduliert wird. In diesem Falle wirkt der geringfügige Abstand zwischen den Kontaktflächen 5 und den jeweils unmittelbar benachbarten Abschnitten des Koppelelements 2 wie ein Kurzschluß. Auf eine ohmsche Kontaktierung kann verzichtet werden. Der Chip besitzt einen Kondensator sowie einen Spannungsgleichrichter, um den Kondensator über ein kapazitiv eingekoppeltes Wechselfeld energetisch aufzuladen. Der Kleber 4 wirkt zwischen dem Koppelelement 2 und den Kontaktanschlüssen 5 als Dielektrikum. Für die kapazitive Kopplung ist es ferner nötig, die Anschlußflächen des integrierten Schaltkreises zu vergrößern.

## Patentansprüche

1. Wertdokument mit einem als Chip ausgebildeten integrierten Schaltkreis (3) und einem Koppelelement (2) wobei eine elektrisch leitfähige Verbindung zwischen dem als Chip ausgebildeten integrierten Schaltkreis (3) und dem Koppelelement (2) zum Übertragen von Daten und/ oder Energie von und/ oder zum Chip (3) vorgesehen ist, **dadurch gekennzeichnet, dass** die elektrisch leitfähige Verbindung zwischen dem Chip (3) und dem Koppelelement (2) eine Kleberschicht (4) enthält, wobei die Kleberschicht (4) ein Dielektrikum zwischen dem Koppelelement (2) und einem Kontaktanschluss (5) des Chips (3) bildet und wobei der Chip (3) einen Spannungsgleichrichter und einen Kondensator umfasst.

2. Wertdokument nach Anspruch 1, wobei das Wertdokument eine Banknote ist.

3. Sicherheitselement für ein Wertdokument umfassend einen als Chip ausgebildeten integrierten Schaltkreis (3) und ein Koppelelement (2) zum Übertragen von Daten und/oder Energie von und/oder zu dem als Chip ausgebildeten integrierten Schaltkreis (3), **dadurch gekennzeichnet, dass** das Koppelelement (2) ein, über einen anisotropen Leitkleber (4) elektrisch leitend mit dem integrierten Schaltkreis (3) verbundener Bestandteil des Sicherheitselements ist.

4. Sicherheitselement nach Anspruch 3, wobei das Sicherheitselement ein Sicherheitsfaden ist.

5. Sicherheitselement nach Anspruch 3 oder 4, wobei das Sicherheitselement eine Transferfolie, beispielsweise ein optisch variables Element ist.

6. Sicherheitspapier zur Herstellung eines Wertpapiers umfassend ein Sicherheitselement nach einem der Ansprüche 3 bis 5.
